# FASCICULE DE BREVET EUROPEEN

(11) **EP 0 389 390 B1**
(45) Date de publication et mention de la délivrance du brevet: **10.08.1994**
(21) Numéro de dépôt: 90420142.3
(22) Date de dépôt: 19.03.1990
(51) Int. Cl.: G01R 33/028

(54) **Micromagnétomètre à poutre fléchissante**
Mikromagnetometer mit flexiblem Balken
Micromagnetometer with flexible bar

(30) Priorité: 21.03.1989 FR 8903963
(43) Date de publication de la demande: 26.09.1990
(73) Titulaire: SEXTANT AVIONIQUE S.A., F-92366 Meudon la Forêt Cédex (FR)
(72) Inventeur: Donzier, Eric, F-74000 Annecy (FR); Thomas, Isabelle, F-26000 Valence (FR); Spirkovitch, Serge, F-75015 Paris (FR); Baillieu, François, F-94440 Marolles En Brie (FR)
(74) Mandataire: de Beaumont, Michel

(56) Documents cités:
- FR-A- 2 425 647
- GB-A- 857 459
- GB-A- 2 136 581

## Description

La présente invention concerne un micromagnétomètre.

Il est connu, par exemple à partir du brevet français 2 542 453 du Centre Electronique Horloger, de fabriquer des micromagnétomètres en utilisant les technologies mises au point dans le domaine de la fabrication des circuits intégrés sur silicium. L'élément sensible de ces micromagnétomètres est constitué à partir d'une aile ou volet gravé dans un bloc de silicium et solidaire de parties restantes de ce bloc de silicium. Dans le cas du brevet susmentionné, la liaison entre le volet et le bloc de silicium est une liaison par des attaches ou bras de torsion en silicium. Une partie au moins d'un bobinage est formée sur le volet. Le volet est donc soumis à une force quand un courant parcourt le bobinage et qu'un champ magnétique externe est appliqué. A courant constant, la rotation du volet (qui ne se déforme pas) est indicative de l'intensité du champ magnétique.

Ce dispositif de l'art antérieur nécessite pour la détection du déplacement du volet une détection de type capacitif qui impose des conditions difficiles à satisfaire dans un dispositif pratique qui aura notamment des bras de dimensions réduites, ce qui rend le dispositif fragile.

Le document WO-A-8808522 décrit un accéléromètre à membrane déformable et à détection piézorésistif qui peut également être utilisé en magnétomètre.

Ainsi, la présente invention a pour objet de prévoir un micromagnétomètre plus simple à fabriquer, plus robuste, et dans lequel la détection d'un déplacement est réalisée plus simplement.

Ces objets de la présente invention sont atteints en prévoyant un micromagnétomètre comprenant au moins une poutre encastrée dont une des surfaces principales porte une partie d'un enroulement, constitué d'une métallisation, et dont une des surfaces principales comprend des moyens piézorésistifs de détection de contrainte, ladite au moins une poutre étant encastrée dans un pied unique formé d'une seule pièce avec elle.

Selon un mode de réalisation de la présente invention, ladite poutre est encastrée dans un pied formé d'une seule pièce avec elle à partir d'un bloc de silicium.

Selon un mode de réalisation de la présente invention, ledit enroulement est parcouru par un courant alternatif de fréquence égale à la fréquence de résonance mécanique de la poutre obtenu par un circuit d'asservissement en utilisant la sortie des moyens piézorésistifs.

Selon un mode de réalisation de la présente invention, chaque poutre comprend une région amincie en forme de bande le long de sa ligne d'encastrement.

Selon un mode de réalisation de la présente invention, il est prévu un circuit d'asservissement constitué de conducteurs disposés en regard des poutres et parcourus par un courant pour fournir un champ de contre-réaction propre à s'opposer au champ extérieur à mesurer.

Selon un mode de réalisation de la présente invention, l'enroulement est constitué de plusieurs enroulements élémentaires formés dans des plans superposés et isolés entre eux.

Selon un mode de réalisation de la présente invention, l'enroulement est une métallisation d'aluminium disposée selon des spires concentriques, la spire la plus externe allant d'une poutre à l'autre, au bord de ces poutres.

Ainsi, le micromagnétomètre selon l'invention est basé sur l'utilisation d'une poutre fléchissante et non pas sur la torsion d'un bras support. Ceci entraîne un avantage de robustesse et permet une détection par des sondes piézorésistives incorporées dans la poutre ou aile fléchissante réalisée en un matériau semi-conducteur. L'un des avantages résultant d'une détection piézorésistive, plutôt que d'une détection capacitive, est que l'on s'affranchit de nombreuses contraintes liées à la distance entre le volet mobile et une plaque de référence, distance qui doit être aussi faible que possible dans le cas d'une détection capacitive, pour augmenter la valeur de la capacité. De plus, dans le cas d'une détection capacitive, si on arrive à réaliser une distance plaque/volet très faible, on est conduit à faire fonctionner le dispositif sous vide pour éviter l'amortissement produit par la mince couche d'air existant entre le volet et la plaque de référence.

Ces objets, caractéristiques et avantages de la présente invention seront illustrés plus en détail dans la description suivante de modes de réalisation particuliers faite en relation avec les figures jointes parmi lesquelles :
les figures 1A et 1B représentent des vues en coupe extrêmement schématiques d'un aspect général de la présente invention ;
les figures 2A et 2B représentent des vues en perspective d'un mode de réalisation de la présente invention en ce qui concerne la structure mécanique ;
la figure 3 représente une vue de dessus d'un dispositif tel que celui des figures 2A et 2B ;
la figure 4 représente de façon plus détaillée un exemple de détecteur piézorésistif adapté à la présente invention ;
la figure 5 représente un exemple de circuits électriques d'un magnétomètre selon la présente invention ; et
la figure 6 représente en A-E des vues de dessus de diverses variantes de structures selon la présente invention.

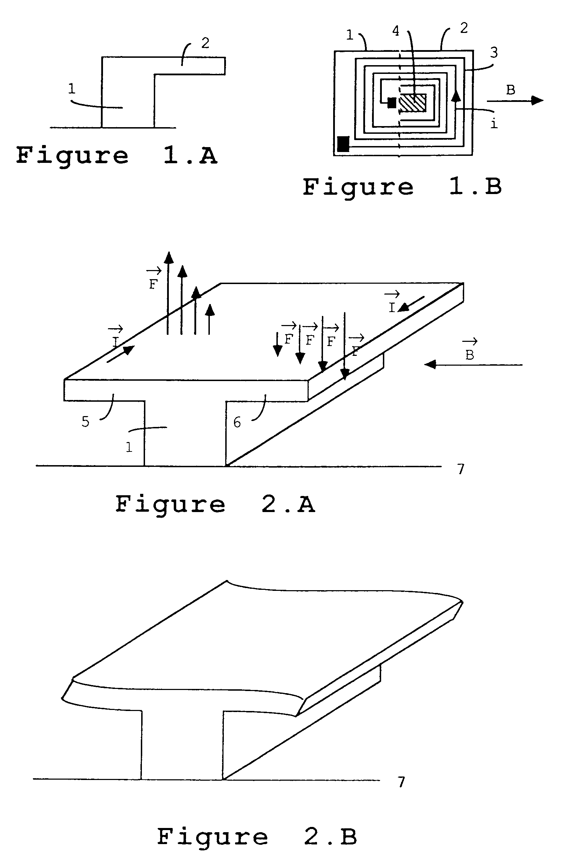

Les figures 1A et 1B sont des vues de côté et de dessus, respectivement, destinées à illustrer un aspect fondamental de la présente invention. Celle-ci prévoit d'utiliser un bloc de silicium unique comprenant un pied 1 et une aile 2. Dans ce qui précède, l'expression bloc de silicium désigne en fait un bloc de très petites dimensions formé à partir d'une plaquette de silicium telle que l'on en utilise dans le domaine des circuits intégrés, c'est-à-dire une plaquette ayant une épaisseur de l'ordre de 0,3 à 0,5 mm. La hauteur totale du pied 1 correspond sensiblement à l'épaisseur de la plaquette de silicium, c'est-a-dire qu'elle est de l'ordre de 0,3 à 0,5 mm. En utilisant les techniques usuelles de fabrication des circuits intégrés, et des techniques dérivées, de nombreux dispositifs identiques pourront être fabriqués à partir d'une même plaquette, des lots de plaquettes étant traités simultanément.

Comme le représente la figure 1B, la face supérieure de la structure de la figure 1A est recouverte d'un enroulement 3 constitué normalement d'une métallisation telle qu'une métallisation d'aluminium. Ainsi, si des portions parallèles de l'enroulement sont traversées par un courant marqué par la flèche i normalement à un champ B, une force s'exercera sur l'aile 2 qui se déformera selon les règles applicables aux poutres fléchissantes encastrées. Une zone 4 de l'aile 2 est munie de moyens de détection de la déflexion, ces moyens pouvant être de façon classique un pont piézorésistif constitué de 4 zones dopées du type de polarité opposé à celui du substrat de silicium. Des contacts pris sur la surface supérieure du pied permettent l'alimentation de l'enroulement 3 et la connexion des bornes du pont de détection. C'est là un avantage des systèmes à poutres fléchissantes que de permettre cette détection par des voies piézorésistives.

En outre, pour obtenir des déplacements de plus grande amplitude de la poutre, le courant électrique circulant dans l'enroulement sera de préférence à une fréquence correspondant à la fréquence de résonance de la poutre.

De préférence, comme le montre la vue en perspective de la figure 2A, on utilisera un système à deux poutres encastrées symétriquement 5 et 6 pour permettre d'améliorer la détection et notamment de s'affranchir des effets d'accélération parasites éventuels qui auraient des effets identiques sur chacune des deux poutres. La figure 2B est une vue en perspective analogue à la figure 2A représentant un état de déformation pris par la poutre quand un courant passe et qu'un champ est appliqué (on notera qu'en cas d'accélération, les déplacements des deux moitiés de poutre seraient dans le même sens). Cet état de déformation résulte des orientations du champ B, du courant I et des forces F indiquées en figure 2A.

A titre d'exemple d'un dispositif pratique, comme cela a été indiqué précédemment, le pied 1 peut avoir une hauteur de 0,3 à 0,5 mm, chacune des ailes sensibles peut avoir une épaisseur de l'ordre de 15 micromètres, chacune de ces ailes 5 et 6 peut avoir une longueur en débordement par rapport au pied de l'ordre du millimètre et une largeur de l'ordre de 2 millimètres, le pied lui-même ayant une longueur, c'est-à-dire une distance entre les encastrements des poutres, de l'ordre du millimètre. L'encombrement total du dispositif est donc de 2x3 mm. Avec de telles dimensions, la fréquence de résonance mécanique des ailes est de l'ordre de la vingtaine de kilohertz. Plusieurs dispositifs de ce type peuvent être formés simultanément sur une plaquette de circuit intégré par gravure anisotrope. Des dispositifs de dimensions nettement inférieures pourront également être réalisés par l'homme de l'art.

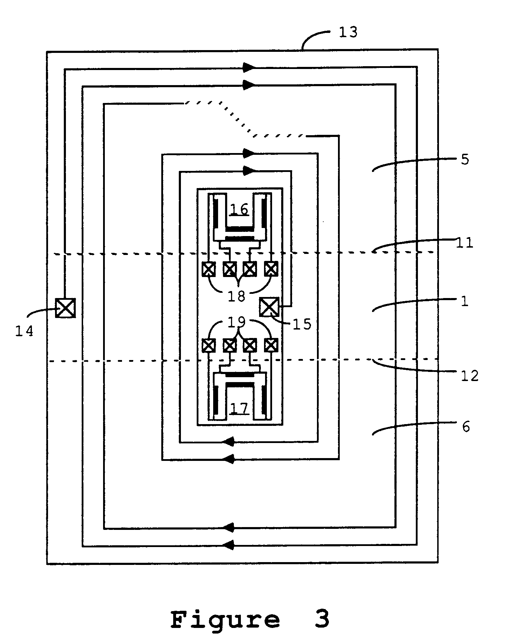

La figure 3 représente un exemple d'une vue de dessus d'une structure telle que celle de la figure 2A. Les pointillés 11 et 12 représentent la limite de chacune des ailes 5, 6 ou en d'autres termes leurs zones d'encastrement avec le pied 1. Une métallisation 13 est enroulée entre un plot externe 14 et un plot interne 15. Dans la zone centrale de la structure, à la limite de chaque encastrement d'aile, sont formés des détecteurs piézorésistifs en pont 16 et 17 qui seront décrits plus en détail ci-après et dont les bornes d'accès sont reliées à des plots 18 et 19, respectivement, ces plots, comme les plots 14 et 15, étant formés sur le pied central 1 de la structure. Les piézorésistances sont constituées de zones diffusées de type de conductivité opposé à celui du substrat de silicium constituant la structure.

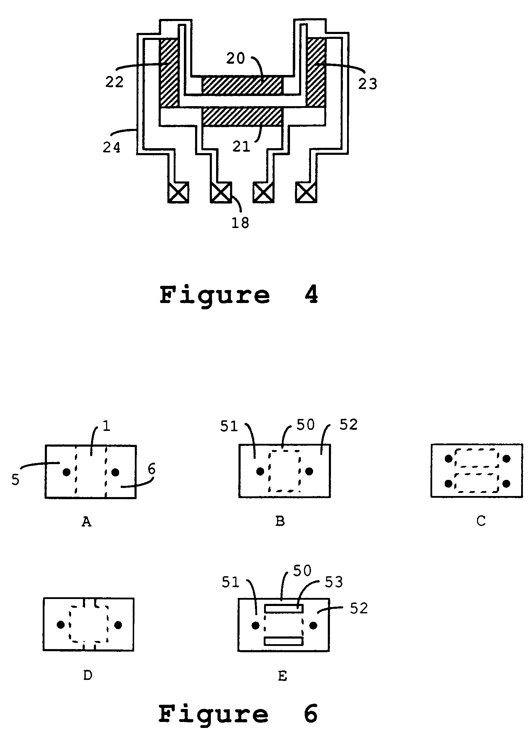

La figure 4 représente un exemple de réalisation de détecteur en pont selon la présente invention dont la structure présente par rapport à une structure classique en carré l'avantage de limiter l'influence des courants induits.

Ce détecteur comprend quatre zones diffusées sensiblement rectilignes, deux à deux othogonales, et deux à deux parallèles 20, 21 et 22, 23. Ces zones sont reliées les unes aux autres et à des plots d'accès 18 par des métallisations 24. Ces zones et les métallisations sont disposées pour qu'il n'existe pas entre elles d'étendue fermée de surface importante. Ainsi, dans la figure 4, les régions parallèles 20 et 21 sont très proches l'une de l'autre.

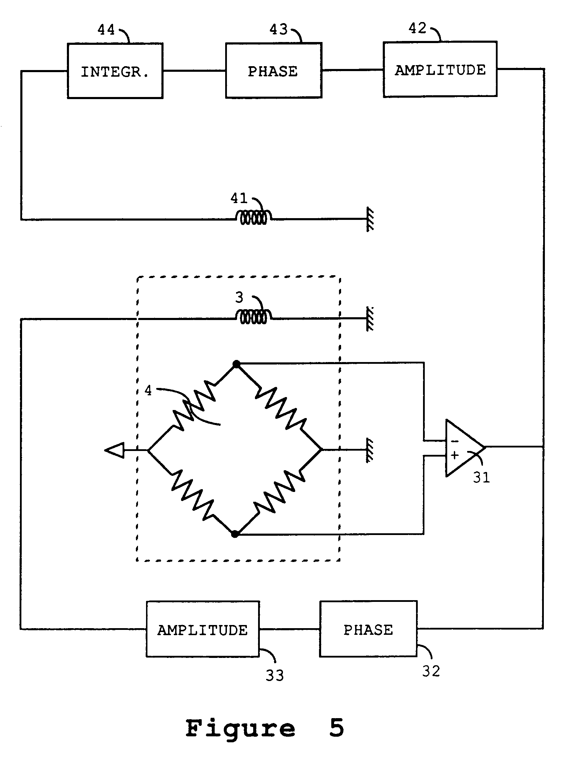

Comme on l'a indiqué précédemment, la structure selon la présente invention fonctionne de préférence avec un courant alternatif dans l'enroulement 3, 13, à une fréquence correspondant à la fréquence de résonance mécanique des poutres. Un asservissement sur la fréquence de résonance peut être obtenu avec un circuit du type de celui représenté en figure 5, qui correspond au cas simplifié de la structure des figures 1A et 1B. La sortie du détecteur 4 est rebouclée sur l'enroulement capteur 3 par l'intermémédiaire d'un amplificateur 31, d'un circuit correcteur de phase 32 et d'un circuit de contrôle d'amplitude 33. On obtient ainsi un oscillateur dont la fréquence se centre sur la ou l'une des fréquences de résonance mécanique de la poutre.

En outre, la sensibilité du système étant élevée, on pourra préférer asservir le champ magnétique au niveau du capteur à une valeur très faible en créant un champ de contre-réaction voisin du champ extérieur à mesurer et de signe opposé. La mesure consistera alors à déterminer la valeur du champ de contre-réaction, par exemple par la mesure du courant qui lui a donné naissance.

Le champ de contre-réaction résulte par exemple du courant fourni par un ou plusieurs conducteurs formés sur le support sur lequel est disposée la structure selon l'invention. Ce support est par exemple une plaque de céramique 7 (voir figure 2A) sur laquelle est collée la base du pied 1 de la structure selon l'invention. Ces conducteurs s'étendent parallèlement à la ligne d'encastrement de la poutre, c'est-à-dire parallalèlement aux conducteurs de l'enroulement 3 de la figure 1B de façon à produire au niveau de l'aile un champ sensiblement parallèle et opposé au champ extérieur à mesurer. Les conducteurs de contre-réaction sont schématisés en figure 5 par l'enroulement 41. Le circuit de contre-réaction utilise la sortie de l'amplificateur 31 et l'applique à la bobine 41 par l'intermédiaire d'un détecteur d'amplitude 42, d'un correcteur de phase 43 et d'un intégrateur 44.

Les circuits de la figure 5 seront simplement mis en oeuvre par l'homme de l'art qui pourra en réaliser de nombreuses variantes. Notamment, dans le cas d'un capteur du type de celui des figures 2A, 2B et 3, on utilisera de préférence des circuits symétriques permettant de doubler la sensibilité et de s'affranchir de divers artéfacts.

Une structure selon la présente invention sera en pratique montée de sorte que le pied est fixé à un substrat 7 et qu'un capot supérieur (non représenté) vient en particulier reprendre le contact sur les plots 14, 15, 18 et 19 apparaissant sur la surface supérieure du pied de la structure. Ce capot sera de préférence un capot étanche permettant de placer la structure dans une atmosphère contrôlée. Toutefois, avec une structure selon l'invention, les ailes fléchissantes peuvent être relativement éloignées du support et l'amortissement dû à la lame d'air interstitielle est négligeable. Il n'est donc pas nécessaire dans le cas général de mettre la structure sous vide.

Une étude théorique du fonctionnement des poutres fléchisantes montre que les détecteurs piézorésistifs doivent de préférence être placés comme cela a été représenté au voisinage de la zone d'encastrement de chacune des poutres car c'est l'emplacement où l'allongement est maximal quand la poutre oscille.

On peut aussi montrer que le signal électrique recueilli et le rapport signal sur bruit sont inversement proportionnels à l'épaisseur de la poutre et ne dépendent pratiquement d'aucune autre dimension. Il en résulte, d'une part, qu'un dispositif selon l'invention est simple à fabriquer et peu sensible à des fluctuations des paramètres de fabrication et, d'autre part, que le dispositif peut être considérablement miniaturisé.

La figure 6 illustre divers exemples de vues de dessus d'un capteur selon la présente invention. Dans la vue de dessus A, on retrouve le capteur qui a été précédemment décrit. Un inconvénient de cette structure pourrait être que, s'il existe de légères différences entre les dimensions des deux ailes symétriques 5 et 6, celles-ci vont avoir des fréquences propres différentes. Il est donc prévu de réaliser un couplage mécanique entre les deux ailes pour obtenir une oscillation à la même fréquence. Les vues de dessus B, C, D et E représentent des exemples de tels couplages, qui impliquent une liaison par une ou plusieurs plaques de liaison 50 entre les deux ailes 51 et 52. Ces plaques de liaison sont latérales dans le cas B, latérales et centrale dans le cas C, latérales mais interrompues par une largeur de pied restante très faible dans le cas D et latérales et séparées du pied central par un évidement 53 dans le cas E.

Dans ce qui a été décrit précédemment, le dispositif était utilisé en micromagnétomètre, les indications des deux détecteurs piézorésistifs étant combinées pour éliminer les flexions de même sens. Le dispositif selon la présente invention peut également fonctionner en accéléromètre si au contraire les indications de sortie des détecteurs piézorésistifs sont combinées de façon additive quand les deux poutres se déplacent dans le même sens. Un tel accéléromètre sera peu sensible puisqu'on a sélectionné des ailes de faible masse pour une bonne détection de l'influence des champs magnétiques sur un bobinage mais permettra néanmoins de détecter une accélération importante.

Bien entendu, de nombreuses variantes et modifications de la présente invention apparaîtront à l'homme de l'art. Par exemple, au lieu d'un enroulement en une seule couche tel que décrit précédemment, on pourra prévoir un premier dépôt d'aluminium configuré en bobine comme cela a été décrit, puis un revêtement de l'ensemble de la structure par un isolant et la formation d'une deuxième spire d'aluminium déposée.

Des modifications de forme pourront aussi être apportées aux ailes constituant les poutres encastrées. Par exemple, ces ailes pourront avoir une première épaisseur dans leurs parties éloignées de l'encastrement et une deuxième épaisseur, plus faible, dans une région en forme de bande longeant la région d'encastrement et comprenant des détecteurs piézorésistifs. A titre d'exemple, la première épaisseur pourrait être de l'ordre de 30 micromètres et la deuxième de l'ordre de 10 micromètres. On obtient ainsi une structure très sensible tout en conservant une bonne rigidité aux ailes.

## Revendications

1. Micromagnétomètre comprenant au moins une poutre encastrée (2 ; 5, 6) dont une des surfaces principales porte une partie d'un enroulement (3), constitué d'une métallisation, et dont une des surfaces principales comprend des moyens piézorésistifs de détection de contrainte (4 ; 20-23), ladite au moins une poutre étant encastrée dans un pied unique (1) formé d'une seule pièce avec elle.

2. Micromagnétomètre selon la revendication 1, caractérisé en ce qu'il est formé à partir d'un bloc de silicium.

3. Micromagnétomètre selon la revendication 1, caractérisé en ce que ledit enroulement est parcouru par un courant alternatif de fréquence égale à la fréquence de résonance mécanique de la poutre obtenu par un circuit d'asservissement (31-33) en utilisant la sortie des moyens piézorésistifs.

4. Micromagnétomètre selon la revendication 1, caractérisé en ce que chaque poutre comprend une région amincie en forme de bande le long de sa ligne d'encastrement.

5. Micromagnétomètre selon la revendication 1, caractérisé en ce que deux poutres symétriques (5, 6) s'étendent de part et d'autre d'un pied (1), un même enroulement (13) étant formé sur l'ensemble des deux poutres.

6. Micromagnétomètre selon la revendication 5, caractérisé en ce que les poutres (5, 6) s'étendent latéralement de part et d'autre du pied, sur une faible étendue, et se rejoignent, de façon à assurer un couplage des poutres.

7. Dispositif selon l'une quelconque des revendications 1 à 6, caractérisé en ce qu'il est associé à un circuit d'asservissement (41-44) constitué de conducteurs (41) disposés en regard des poutres et parcourus par un courant pour fournir un champ de contre-réaction propre à s'opposer au champ extérieur à mesurer.

8. Micromagnétomètre selon la revendication 2, caractérisé en ce que le détecteur piézorésistif est constitué d'un pont de résistances (20-23) formées par diffusion d'un dopant du type de conductivité opposé dans le silicium formant les poutres, en ce que ce détecteur est disposé au voisinage du pied (1), et en ce qu'il comprend quatre résistances disposées deux à deux parallèlement et reliées de façon à délimiter une région de surface minimale.

9. Micromagnétomètre selon la revendication 5, caractérisé en ce que l'enroulement (13) est une métallisation d'aluminium disposée selon des spires concentriques, la spire la plus externe allant d'une poutre à l'autre, au bord de ces poutres.

10. Micromagnétomètre selon l'une quelconque des revendications 1 à 9, caractérisé en ce que l'enroulement est constitué de plusieurs enroulements élémentaires formés dans des plans superposés et isolés entre eux.

## Patentansprüche

1. Mikromagnetometer mit zumindest einem gehaltenen Balken (2; 5, 6), bei dem eine der Hauptoberflachen einen Teil einer aus einer Metallisierung bestehenden Wicklung (3) trägt und eine der Hauptoberflächen piezoresistive Einrichtungen (4; 20 bis 23) zum Erfassen von Belastungen aufweist, wobei der zumindest eine Balken an einem einstückig mit diesem ausgebildeten einzigen Fuß (1) gehalten ist.

2. Mikromagnetometer nach Anspruch 1, dadurch gekennzeichnet, daß es aus einem Siliziumblock geformt ist.

3. Mikromagnetometer nach Anspruch 1, dadurch gekennzeichnet, daß die Wicklung von einem Wechselstrom mit einer Frequenz gleich der mechanischen Resonanzfrequenz des Balkens durchflossen ist, wobei dieser Strom durch eine Steuerschaltung (31 bis 33) geliefert wird, die das Ausgangssignal der piezoresistiven Einrichtungen verwendet.

4. Mikromagnetometer nach Anspruch 1, dadurch gekennzeichnet, daß jeder Balken einen dünneren Bereich in Form eines Streifens entlang der Linie seiner Halterung aufweist.

5. Mikromagnetometer nach Anspruch 1, dadurch gekennzeichnet, daß zwei symmetrische Balken (5, 6) sich jeweils zu einer Seite eines Fußes (1) erstrecken, wobei eine einzige Wicklung (13) auf der Anordnung der beiden Balken ausgebildet ist.

6. Mikromagnetometer nach Anspruch 5, dadurch gekennzeichnet, daß die Balken (5, 6) sich seitlich zu beiden Seiten des Fußes über eine geringe Ausdehnung erstrecken und miteinander vereinigt sind, um eine Kopplung der Balken sicherzustellen.

7. Vorrichtung nach einem der Ansprüche 1 bis 6, dadurch gekennzeichnet, daß sie mit einer Steuerschaltung (41 bis 44) verbunden ist, die gegen die Balken gerichtete Leiter (41) aufweist, welche von einem Strom durchflossen sind, um ein Gegenfeld zu dem äußeren zu messenden Feld zu liefern.

8. Mikromagnetometer nach Anspruch 2, dadurch gekennzeichnet, daß der piezoresistive Detektor durch eine Widerstandsbrücke (20 bis 23) gebildet wird, wobei die Widerstände durch Diffusion eines Dotierungsmittels des entgegengesetzten Leitungstypes in dem die Balken bildenden Silizium gebildet werden, daß der Detektor zu dem Fuß (1) benachbart gelegen ist und daß er vier Widerstände aufweist, die jeweils paarweise parallel angeordnet und miteinander verbunden sind, um einen minimalen Oberflächenbereich zu benötigen.

9. Mikromagnetometer nach Anspruch 5, dadurch gekennzeichnet, daß die Wicklung (13) eine Metallisierung aus Aluminium ist, die in konzentrischen Windungen angeordnet ist, wobei die äußerste Windung von einem Balken zu dem anderen längs des Randes dieser Balken läuft.

10. Mikromagnetometer nach einem der Ansprüche 1 bis 9, dadurch gekennzeichnet, daß die Wicklung aus mehreren elementaren Wicklungen besteht, die in gegenüberliegenden Ebenen ausgebildet und voneinander isoliert sind.

## Claims

1. A micromagnetometer including at least one embedded beam (2; 5,6) one of the main surfaces of which carries a portion of a winding (3) that is formed by a metallization, and one of the main surfaces of which includes piezo-resistive means for detecting stresses (4; 20-23), said at least one beam being embedded in a single foot (1) integral therewith.

2. The micromagnetometer of claim 1, characterized in that it is formed in a silicon block.

3. The micromagnetometer of claim 1, characterized in that an a.c. current having a frequency equal to the mechanic resonance frequency of the beam flows in said winding, said current being provided by a control circuit (31-33) by using the output of the piezo-resistive means.

4. The micromagnetometer of claim 1, characterized in that each beam includes a thinner region shaped like a strip along its embedment line.

5. The micromagnetometer of claim 1, characterized in that two symmetrical beams (5, 6) extend on both sides of a leg (1), a single winding (13) being formed on the two beams.

6. The micromagnetometer of claim 5, characterized in that said beams (5, 6) extend laterally on both side of the leg, over a small length, and contact each other, so as to provide coupling of the beams.

7. The device of any of claims 1 to 6, characterized in that it is associated with a control circuit (41-44) formed by conductors (41) facing the beams and conducting a current to provide a negative feedback field opposed to the external field to be measured.

8. The micromagnetometer of claim 2, characterized in that the piezo-resistive detector is constituted by a set of resistors (20-23) formed by diffusing a dopant having a conductivity type opposite into the silicon forming the beam, and said detector is disposed near the leg (1), said resistors including four resistors, pairs of which are parallel disposed and connected so as to delineate a minimum surface region.

9. The micromagnetometer of claim 5, characterized in that said winding (13) is an aluminum metallization disposed in concentric turns, the extreme external turn running from a beam to the other, along the edge of said beams.

10. The micromagnetometer of any one of claims 1 to 9, characterized in that the winding is constituted by a plurality of elementary windings that are formed within superposed planes and are isolated one from the other.
